# EUROPEAN PATENT SPECIFICATION

(11) **EP 1 518 599 B1**
(45) Date of publication and mention of the grant of the patent: **11.02.2009**
(21) Application number: 04425406.8
(22) Date of filing: 01.06.2004
(51) Int. Cl.: C23C 14/34, C23C 14/14, B01J 20/32, B01J 20/02

(54) **Non-evaporable getter multilayer deposits obtained by cathodic deposition and process for their manufacturing**
Nicht-verdampfbare Getter-Vielschicht-Abscheidungen erhalten durch kathodische Abscheidung und Verfahren zu deren Herstellung
Dépôts multicouche de getter non evaporable obtenu par déposition cathodique et procédé de fabrication

(30) Priority: 11.06.2003 IT MI20031178
(43) Date of publication of application: 30.03.2005
(73) Proprietor: SAES GETTERS S.p.A., 20020 Lainate (Milano) (IT)
(72) Inventor: Conte, Andrea, 20154 Milano MI (IT); Moraja, Marco, 20161 Milano MI (IT)
(74) Representative: Adorno, Silvano

(56) References cited:
- US-A- 6 110 808
- US-B1- 6 554 970
- BENVENUTI C ET AL: "Vacuum properties of TiZrV non-evaporable getter films [for LHC vacuum system]" VACUUM ELSEVIER UK, vol. 60, no. 1-2, January 2001 (2001-01), pages 57-65, XP002327154 ISSN: 0042-207X
- BENVENUTI C ET AL: "Vacuum properties of palladium thin film coatings" VACUUM ELSEVIER UK, vol. 73, no. 2, 19 March 2004 (2004-03-19), pages 139-144, XP002327155 ISSN: 0042-207X

## Description

The present invention relates to non-evaporable getter multilayer deposits obtained by cathodic deposition and to a process for their manufacturing.

The main non-evaporable getter materials, also known in the art as NEG materials, are some transition metals such as Zr, Ti, Nb, Ta, V, or alloys or compounds thereof and/or with one or more elements selected among Cr, Mn, Fe, Co, Ni, Al ,Y, La and Rare Earths, such as for example binary alloys Ti-V, Zr-Al, Zr-V, Zr-Fe and Zr-Ni, ternary alloys Zr-V-Fe and Zr-Co-Rare Earths, or multi-components alloys.

NEG materials are capable of reversibly sorbing hydrogen and irreversibly sorbing gases such as oxygen, water, carbon oxides and, in some cases, nitrogen. Therefore, these materials are used for keeping vacuum in applications requiring it, such as for example evacuated interspaces for thermal insulation; getter materials can also be employed to remove the above-mentioned species from inert gases, mainly rare gases, for example in gas-filled lamps or for manufacturing of ultrapure gases such as those used in the microelectronic industry.

The functioning of NEG materials is based on the chemical reaction among the NEG metallic atoms and the atoms of the above-mentioned gaseous species. At room temperature, in consequence of this reaction oxide, nitride or carbide species are formed on the material surface, resulting eventually in the formation of a passivating layer that prevents from further gas sorbing. The passivating layer can rapidly form in presence of considerable amounts of gas, for example at the first exposure to the atmosphere of the freshly produced NEG material, or during certain "dirty" manufacturing steps of the devices in which this is contained; furthermore this layer forms, although more slowly, as a result of the NEG functioning itself, in consequence of sorbing gaseous species, which the material removes from the atmosphere at the inside of the final device as time goes on. To allow the correct NEG functioning at the beginning of its operating life a thermal activation treatment (normally under vacuum) is required, whose object is the migration of the passivating layer species towards the inside of the material structure, thereby exposing a metallic surface "fresh" and active for gas sorption. The activation may be complete, thus obtaining a material surface essentially entirely made up of metals, or partial, thus obtaining a "mixed" surface, made up of areas of oxide-type species (or the like) and metallic areas; an activation degree (generally expressed in percentage) can thus be defined, that will correspond to the fraction of "free" surface sites, i.e. metals at the elementary state and consequently available for reaction with gases. The activation advancement can be controlled through the process temperature and time; for example an activation degree of 70% of a given material can be reached by treatment for half an hour at 350 °C or for 10 hours at 250 °C: according to a rule generally valid in chemical reactions, the effect of temperature on the reaction advancement degree is much greater than that of time. Generally, to completely activate a NEG would be always preferable, but it may be impossible in the manufacturing of certain devices owing to manufacturing times, or because the device wouldn't tolerate too high temperatures necessary to the purpose: in these cases, the producers of devices containing NEG materials are satisfied with a partial activation, even though they have to accept lower gas sorbing properties (for example, shorter NEG operating life). The conditions of the activation treatment are different according to the material, depending on the physical-chemical characteristics thereof. For some materials a complete activation treatment requires even very high temperatures; for example, the alloy of weight percent composition Zr 84% - Al 16%, requires thermal treatments at 700 °C at least and preferably at about 900 °C (unless extremely long times are adopted, unacceptable in an industrial production); other alloys, such as some ternary alloys Zr-V-Fe, have much lower activation temperatures and can be activated at 100% at about 350 °C in about one hour. In some cases, the activation treatment can be periodically repeated (processes called of reactivation) during the device operating life, to restore the initial NEG gas sorbing properties. In the following and in the claims, by the definition of "low activation temperature" material, it will be meant a material (metal, intermetallic compound or alloy) which can be activated for at least 90% by a treatment of one hour at a maximum temperature of 300 °C.

NEG materials can be employed in the form of discrete devices, for example sintered pills or powders of the material within suitable containers. In some applications, for reasons of available space or for simplicity of construction, it is required the use of NEG materials in the form of thin layers, having thickness generally of tens or hundreds of micron (µm), placed on an inner surface of the final apparatus: the NEG material can be deposited on a thin support, generally metallic, subsequently brought into contact with the surface, but preferably the deposit is directly formed thereon. Examples of uses of thin layers of NEG material are disclosed in US patent 5,453,659, that describes Field Emission Displays (known in the art as FEDs) wherein discrete and thin deposits of NEG material are formed among the electrons emitting cathodes on the anodic plate of the display; in US patent 6,468,043, that describes the coating with a NEG layer of the inner surface of the pipes defining the chamber of a particles accelerator; in US patents 5,701,008 and 6,499,354, that describe, respectively, the use of getter materials in micromechanical devices and in miniaturized IR radiation detectors (micromechanical or microoptoelectronic devices are known in the art as "micromachines" or MEMs) and finally, in the paper "Vacuum properties of TiZrV non-evaporable getter films [for LHC vacuum system]" of C. Benvenuti et al., Vacuum, vol.60 (2001), pages 57-65, regarding in particular the use of such NEG layers in partcle beam chambers. In all these applications, the NEG deposit (after activation) works at room temperature.

The more convenient technique for the NEG deposit formation is the cathodic deposition, better known in the art as sputtering. On this technique, well known and broadly used for the production of thin layers, is based the whole microelectronic industry; since also FEDs and MEMs are manufactured by using this technique (among others), for reasons of production integration the same technique results to be preferred also for manufacturing NEG material layers in these devices.

As it is well known, in the sputtering technique a vacuum chamber is used wherein it is possible to generate an electrical field. Inside the chamber there are placed a target (generally in the form of a short cylinder) of the material to be deposited and in front of this, the support on which the thin layer has to be formed. The chamber is firstly evacuated and then backfilled with a noble gas atmosphere, generally argon, at a pressure generally from about 0.1 to 1 Pa. By applying a potential difference of a few thousands volts between the stands of the support and of the target (so that the latter is at cathodic potential), a plasma of Ar⁺ ions is created; these ions are accelerated by the electrical field towards the target and cause its erosion through impact; the species (generally atoms or atoms clusters) derived from target erosion deposit on the support thus forming the thin layer. In a variation of the method commonly used, a magnetic field is applied to the plasma region, helping to confine the plasma itself and improving the characteristics of cathode erosion and deposit formation; this variation is defined in the art as "magnetron sputtering". The deposit can entirely cover the support surface, obtaining a single continuous deposit; otherwise, through suitable maskings, deposits on only certain support regions can be obtained.

For various reasons, however, the NEG deposits up to now obtained by sputtering are not fully satisfactory for the use in applications in which the deposit has to work at room temperature.

NEG deposits made up of a single metal (and particularly those of titanium, which are the most commonly used) can be easily manufactured by sputtering with open or porous morphology, that increases the effective surface area and consequently the initial gas sorption rate. For an effective activation (or reactivation) pure metals however require comparatively high temperatures, generally higher than 450 °C. In small sized or miniaturized devices such as FEDs or MEMs, wherein the NEG material is quite close to functional or structural parts of the device, the activation treatment can damage these parts. For example, in the case of FEDs in which the NEG is generally placed at the peripheric region, the heating at about 400 °C can compromise the tightness of sealing between the two glass parts forming the display, made up of a low-melting glass paste; similarly, treatments at the indicated temperatures can compromise the sealings between the two silicon parts forming the MEMs, when these are made up e.g. of brazing alloys such as silver-based alloys, or gold-tin or gold-indium alloys.

Certain NEG intermetallic compounds or alloys have the advantage of having low activation temperatures according to the above given definition, for example of about 300 °C or lower. However the present inventors have experimentally determined that these materials having low activation temperature, when deposited by sputtering, give rise to thin layers having extremely compact morphology and consequently a very reduced effective surface area, generally equivalent to few times the deposit geometrical area. This characteristic limits considerably the deposit sorbing properties at room temperature, particularly its initial sorption rate and its capacity, and for example makes necessary frequent reactivations which can be hardly carried out into practice in some applications.

Therefore the known NEG deposits obtained by sputtering have poor sorbing characteristics at room temperature (particularly low sorption rate), or activation temperatures incompatible with some applications, particularly the miniaturized ones.

Object of the present invention is to overcome the drawbacks of the prior art, and particularly to provide NEG material deposits obtained by cathodic deposition, being characterized by low activation temperature and large surface area.

This object is achieved according to the present invention by the multilayer deposit as defined in claim 1.

By the term "getter alloy" (or NEG alloy), as above used, in the following and in the claims, are also meant compositions corresponding to intermetallic compounds, such as for example the ZrV₂ composition; the reason is that depositing by sputtering thin material layers of composition corresponding to an intermetallic, a regular structure typical of these compounds is hardly obtained, on the contrary obtaining an almost amorphous or however irregular structure typical of the alloys.

The multilayer deposits of the invention are such that the layer formed by the low activation temperature NEG alloy directly faces in the final application the space to be kept evacuated or wherein the gas to be purified is present.

The inventors have surprisingly found that a multilayer deposit obtained by sputtering such as the one described, has a very large effective surface area combined with the typical properties (particularly the activation temperature) of certain NEG alloys. In other words, the multilayer deposits of the invention do not act as the mere addition of the two (or more) component layers, but as one single monocomponent layer, the properties of which are the addition of the best properties of the different present layers.

The invention will be in the following described with reference to the drawings, wherein:
- Figure 1 shows in a schematic way in cross-section a NEG multilayer of the invention;
- Figures 2 and 3 show in a schematic way in cross-section possible alternative embodiments of the invention;
- Figure 4 show graphs representative of gas sorbing properties of multilayer deposits of the invention and of deposits formed by a single NEG material of the known art;
- Figure 5 shows two graphs representative of gas sorbing properties of two deposits of the invention.

Getter systems made up of a first material on which a second one is deposited by sputtering are already known from the international publication WO 02/27058 A1. In the systems of this application however the underlying material is not obtained in its turn by sputtering, but it is made up of a macroscopic body of sintered getter powders, and the purpose of the deposit formation by sputtering on the macroscopic body is to reduce the loss of particles from this one. In this case, the presence of the deposit obtained by sputtering does not alter the sorbing or activation characteristics of the system, because the ratio between the volumes and the masses of the two components is such that the presence of the sputtered deposit is negligible to this effect; furthermore, the underlying material is exposed to the atmosphere before the deposit formation by sputtering. On the contrary, in the systems of the invention all the active components (i.e. except for the support) are obtained by sputtering in immediately subsequent process steps; this productive characteristic and the ratio between the quantities of the two materials is such that the presence of the low activation NEG alloy substantially changes the properties of the overall system, particularly the activation ones.

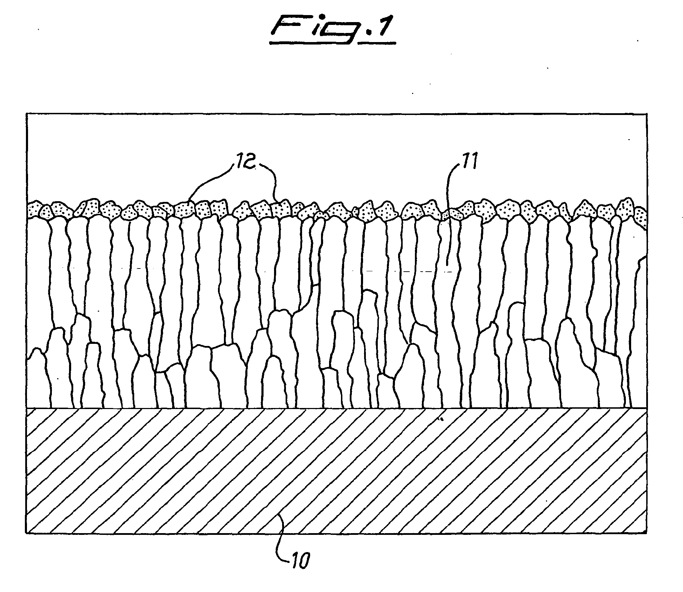

Figure 1 is the reproduction of a microphotograph of a multilayer of the invention seen in cross-section as obtained by scanning electron microscope.

The first layer, 11, of the deposit of the invention is formed on a support, 10. This one can be an additional support being then applied to the inner surface of the device to be kept evacuated or wherein the gas to be purified is present. Preferably however, the support 10 is the inner device surface itself (or a part of this one) when this is allowed by the geometry of the device wherein the NEG must be inserted: it is the case of medium or small sized devices which can be put into a sputtering chamber, such as FEDs or MEMs. The first layer 11 is made up of NEG material that can be deposited by sputtering in the form of layer having large surface area. For this purpose it is possible to use one of the alloys described in US patent 5,961,750, comprising zirconium, cobalt and one or more elements selected among yttrium, lanthanum and Rare Earths, and particularly the alloy having percent composition by weight Zr 80% - Co 15% - A 5% (where A stands for one or more among Y, La and Rare Earths). It is however preferred using a metal selected among niobium, tantalum, vanadium, hafnium, zirconium and titanium, particularly the last two ones. The thickness of layer 11 can range within large limits, not bound by stringent restrictions. The lower thickness limit is essentially determined by the possibility to obtain a layer having the desired morphology: thicknesses lower than 0.2 µm are not advisable because layers having such thicknesses tend to "repeat" the support morphology (which could be not rough) and consequently do not assure to obtain a layer having sufficient surface area; furthermore, since this layer forms the main gas sorbing "reservoir" of the multilayer, its minimum thickness is also determined by the gas quantity that is expected it will be needed to sorb. The maximum thickness is instead determined mainly by productive factors, and particularly by the time necessary for the layer growth; the layers formation rate by sputtering is generally not very high, and consequently it is generally preferred to keep the thickness at values lower than about 50 µm, for example between about 1 and 10 µm if these thicknesses are compatible with the required sorption capacity.

As aforesaid, the layer 11 must have a large surface area, determined by its porosity. It is possible to give an indication on the porosity of these layers obtained by cathodic deposition as ratio between the effective surface area and the geometrical area: this ratio, indicated in the following as Rₑ, is 1 in the theoretical case of a perfectly smooth deposit, and increases with the increasing of the roughness or irregularity of the metallic deposit surface. For the purposes of the invention Rₑ must be greater than 20 and preferably greater than 50.

Over layer 11 there is formed by sputtering at least a second layer, 12, made up of a low activation temperature getter alloy. Getter alloys suitable for the invention are for example the Zr-V-Fe alloys of US patent 4,312,669, particularly the alloy having percent composition by weight Zr 70% - V 24.6% - Fe 5.4%; alloys comprising mainly zirconium and vanadium and smaller amounts of one or more elements selected among iron, nickel, manganese, and aluminum, described in US patent 4,996,002; Zr-Co-A alloys (where A is an element selected among yttrium, lanthanum and Rare Earths and mixtures thereof) described in US patent 5,961,750, particularly the alloy having percent composition by weight Zr 70% - Co 15% - A 5%, when the material of layer 11 is not made up also of a Zr-Co-A-type alloy; Zr-Ti-V alloys, particularly the alloy having percent composition by weight Zr 44% - Ti 23% - V 33%, which can be activated (at least partially) by treatments even of a few hours at 200 °C; and the compound ZrV₂.

This second layer thickness is not greater than 1 µm, and preferably ranging from 50 to 500 nanometer (nm); with these thicknesses the layer keeps the morphological characteristics of the underlying layer 11, and consequently high Rₑ values and high sorption rate, whereas with higher thicknesses the layer becomes more compact and unsuitable for the application at room temperature.

Optionally, on the upper surface of layer 12 it is possible to deposit a further layer, continuous or discontinuous, of palladium or of one compound thereof, which can be palladium oxide, silver-palladium alloys comprising up to atomic 30% of silver and compounds among palladium and one or more metals forming the getter material.

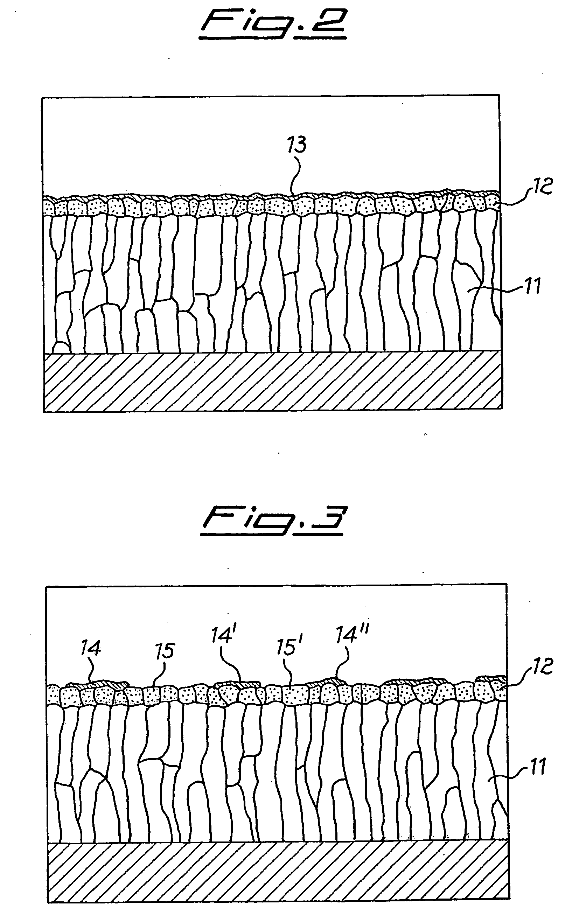

Figure 2 shows the first of these possibilities (continuous layer): in this case, the palladium layer, 13, allows the hydrogen selective sorption; it is known indeed that palladium has high hydrogen permeability, and consequently allows the transfer of this gas towards the underlying getter material layer. To maximize the hydrogen transfer rate to the getter, the palladium deposit must have low thickness, for example ranging from about 10 to 100 nm. Getter deposits made hydrogen selective by coating with a continuous palladium deposit are known for example from international publication WO 98/37958 A1, but in the case of the invention a higher sorbing rate is obtained, due to the larger surface area. Hydrogen selective getter multilayers comprising a continuous layer of metal of high hydrogen permeability (e.g. palladium) over a layer of a getter material are also known from US Pat. No. 6,110,808.

Figure 3 shows the case of a discontinuous deposit of palladium (or a compound thereof). In this case palladium (or palladium compound) is present in the form of "islands" 14, 14', 14", ..., on the getter layer 12 surface; these islands cover preferably from 10 to 90% of the layer 12 surface. Such a configuration is described in international publication WO 00/75950 A1, with reference to getter materials in the form of powders. With this structure a material is obtained being able to act both as a constant hydrogen sorber an as sorber of other gases in consequence of a suitable activation. As more diffusely disclosed in the mentioned international publication, these operation characteristics are due to the fact that the islands 14, 14', 14", ..., not sorbing other gases, do not get passivated and consequently form passages for continuous hydrogen entering into the getter alloy, whereas the zones 15, 15', ..., of the layer 12 surface not covered by said islands keep their usual operation as getters.

In a second aspect thereof, the invention relates to the process for manufacturing the deposits hitherto described.

The process of the invention comprises at least the steps of:
- depositing by cathodic deposition on a support a first layer of a non-evaporable getter material having a surface area equivalent to at least 20 times its geometrical area; and
- depositing by cathodic deposition over said first layer at least a second layer, having thickness not greater than 1 µm, of a non-evaporable getter alloy having low activation temperature;
operating in such way that, between the two mentioned deposition steps, the material of first layer is not exposed to gas species able to react therewith.

The process consists of two subsequent steps of deposition by sputtering of two different materials. The deposition by sputtering occurs according to the procedure known in the art and described in general outline in the introduction, and necessarily requires that the formed first layer is not exposed to species that can react therewith; particularly, the exposure to oxidant species, such as oxygen or water, must be avoided. It is believed that the characteristic of the invention, according to which the low activation temperature alloy "transfers" its activation temperature to the underlying material, depends on the fact that the latter, operating as described, is never subjected to passivation.

As aforesaid, the support on which the first layer 11 having large surface area is deposited can be an additional part, such as for example a support (generally flat) of metal, glass or silicon, which is then placed into the final system at a suitable position. Preferably however, when size and shape of the device intended for the getter deposit allow that, the deposition directly occurs on an inner surface of the device itself, without requiring an additional support; this preferred manufacturing procedure can be employed for example in the production of MEMs and FEDs.

A layer 11 made up of the previously mentioned materials and having high roughness or irregularity (and consequently the required values of Rₑ) can be obtained by sputtering resorting to some expedients known in the art. First, it is possible to cool the support on which the deposition takes place; in this way the atoms reaching the support have not available enough energy to rearrange and form more regular structures, thus achieving a kind of "quenching" of the deposit under formation. For the purpose of keeping low the support temperature, it is also preferable to operate at reduced currents, since with high currents a high number of impacts per time unit would occur between Ar⁺ ions and the target, with a consequent widespread heating of the system. Finally, another possibility is to operate with the target not directly placed in front of the support, or moving, rotating or vibrating the support during the deposition; all these operating modes increase the geometrical disorder of the deposit and consequently promote the formation of not very compact layers. Of course it is possible to use at the same time more procedures of the types here above mentioned to increase the Rₑ value of layer 11.

To form layer 12 the sputtering technique can be used according to its usual procedures, without resorting to the above-mentioned particular expedients to increase the morphological irregularity of the layer 11, which have turned out ineffective in the case of low activation temperature alloys.

The possible deposit of palladium (or its alloys or compounds) must not be necessarily obtained by sputtering, and could be obtained for example by evaporation, using the Chemical Vapor Deposition technique; in the case of metallic palladium or its alloys it is however preferable for convenience that also this deposit is obtained by sputtering.

The invention will be further illustrated through the following examples. These non-limiting examples show some embodiments intended to teach to those skilled in the art how to practise the invention and to represent the considered best way to carry out the invention.

### EXAMPLE 1

This example regards the preparation of a double-layered deposit according to the invention.

As support for the deposition a polished monocrystalline silicon disc is used having a diameter of 2.5 cm, which is cleaned in an ultrasonic bath with an organic solvent (an alcoholic solution of n-propylbromide) and subsequent rinsing in deionized water. The support is placed into a cathodic deposition chamber that can contain up to three targets of different materials, which is evacuated until a pressure of 3×10⁻⁶ Pa is reached and that is subsequently backfilled with argon at a pressure of 2 Pa. A titanium layer is first deposited, with the following operating parameters:
- power density on the target: 3.5 W/cm²;
- target-support distance: 140 mm;
- support temperature: 100 °C;
- deposition time: 80 minutes.

Subsequently a second target of a ZrV₂ alloy is used, a layer of which is deposited on the titanium one employing the same operating parameters of the previous step, except for the power density on the target which is decreased to 3 W/cm² and the deposition time which is limited to 10 minutes.

Finally the support with the double deposit is withdrawn from the deposition chamber and analyzed at the electronic microscope to determine the average thickness of the two layers, resulting to be 3.3 µm for the titanium layer and 0.2 µm for the alloy. These thickness values (as all the thicknesses reported in the following examples) are average values, owing to the defective deposits planarity.

This support with the double deposit is sample 1.

### EXAMPLE 2 (COMPARATIVE)

The procedure of Example 1 is repeated, depositing however only one layer of ZrV₂ alloy. The same operating parameters adopted for the alloy deposition in Example 1 are used, with the exceptions that the chamber is initially evacuated until a residual pressure of 7×10⁻⁶ Pa is reached, and that the deposition is continued for 60 minutes.

The support with the alloy deposit, being sample 2, is extracted from the chamber and analyzed at the electronic microscope to determine the average thickness of the deposit, resulting to be 3.5 µm.

### EXAMPLE 3 (COMPARATIVE)

The procedure of Example 1 is repeated, depositing however only one layer of titanium. The same operating parameters adopted for titanium deposition in Example 1 are used, with the exception that the deposition is continued for 90 minutes.

The support with the titanium deposit, being sample 3, is extracted from the chamber and analyzed at the electronic microscope to determine the average thickness of the deposit, resulting to be 3.5 µm.

### EXAMPLE 4

The procedure of the Example 1 is repeated, with the only difference that the titanium deposition lasts 40 minutes; the sample so obtained (sample 4) has an overall average thickness of 1.8 µm, made up of titanium layer having thickness of 1.6 µm and one of ZrV₂ alloy having thickness of 0.2 µm.

### EXAMPLE 5

In this example, the gas sorbing properties at room temperature of samples 1, 2 and 3 are evaluated.

The samples are mounted one at a time into a quartz bulb, which before every test is evacuated through a turbomolecular pump until a residual pressure of 1×10⁻⁶ Pa is reached; to promote the degassing of the system walls and therefore to accelerate the achievement of the required pressure, during this step the system is heated at 180 °C for about 12 hours.

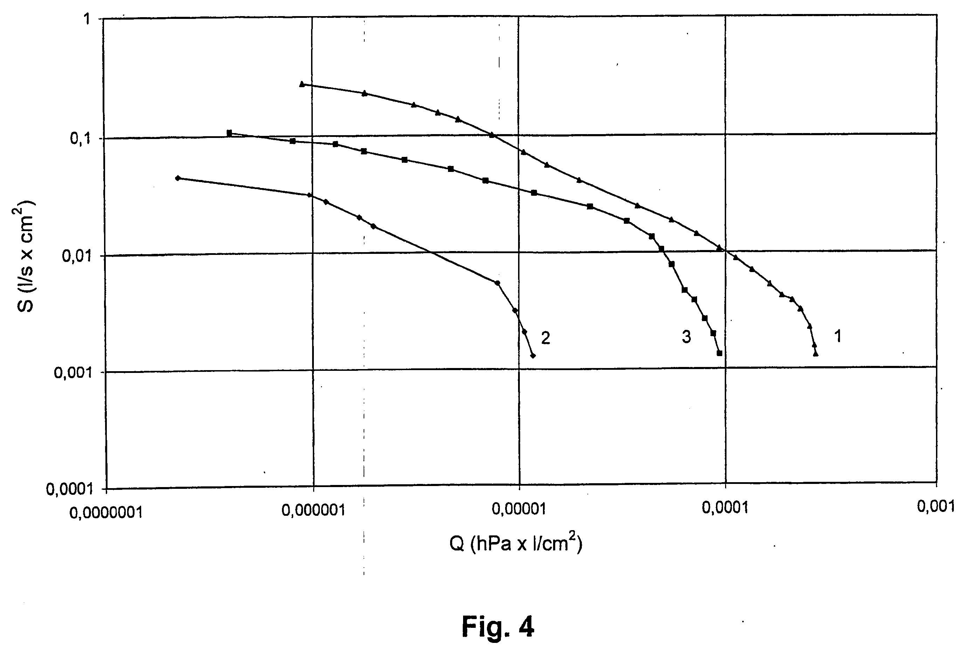

Upon reaching the required residual pressure, the sample object of the test is activated by radiofrequency heating at 300 °C for 30 minutes, through an induction coil placed outside the bulb; the temperature is monitored with an optical pyrometer. The sample is then let cool down to room temperature, and the gas sorption test is carried out according to the procedures described in the standard ASTM F798-82, introducing into the bulb carbon monoxide, CO, at a pressure of 4×10⁻⁴ Pa and recording the pressure decrease downstream a known conductance. The result of the three sorption tests is shown in Figure 4, wherein the number of each curve corresponds to the number of sample as above indicated. The curves show the sample sorbing rate, S, measured in liters of gas sorbed every second per square centimeter of deposit (1/s×cm²), as a function of sorbed gas quantity, Q, measured in liters of gas sorbed, multiplied by the sorption pressure (in hectoPascal, hPa), divided by the deposit surface (hPa×1/cm²). The maximum value of Q of the three curves measures the total samples capacity.

### EXAMPLE 6

In this example, the gas sorption properties at high temperatures of samples 1 and 4 are evaluated.

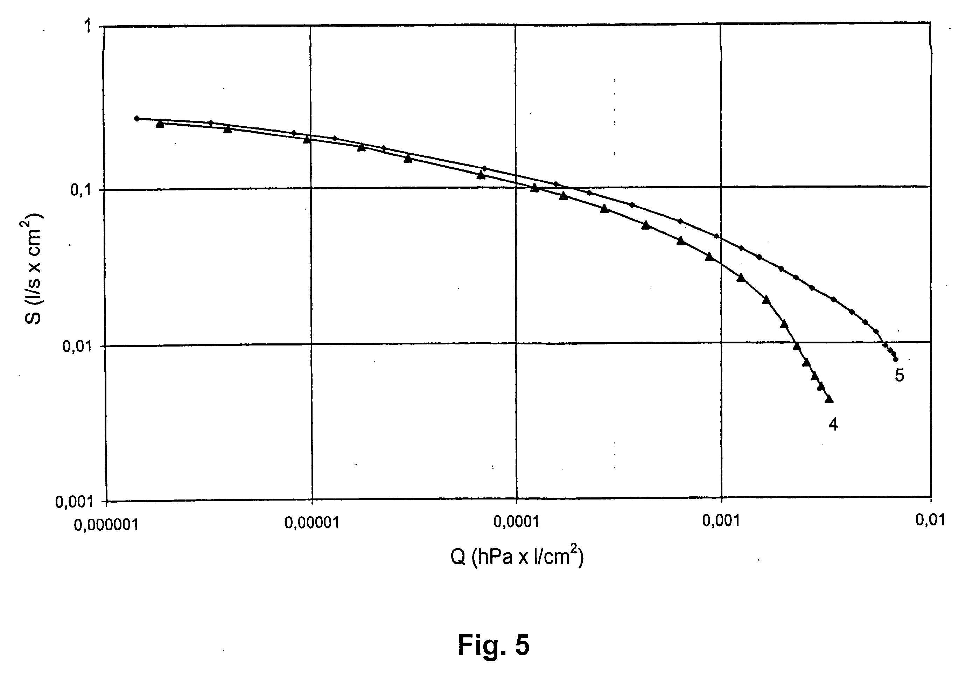

On a second sample prepared exactly as described in Example 1, and on sample 4, CO sorption tests are carried out with procedures similar to those described in Example 5; in these tests the samples are activated by heating at 430 °C, and the two tests are carried out at 300 °C. The two tests results are graphically shown in Figure 5 (wherein the symbols have the same meaning as in Figure 4), as curve 4 for sample 4 and curve 5 for the sample prepared according to Example 1.

Under test conditions of Examples 5 and 6, various characteristics of the deposits of getter materials are measured. In the room temperature tests (Example 5), the species formed on the getter surface as a result of gas sorbing do not have energy enough to diffuse inwards of material: the exhaustion of sorption capacity therefore shows that all the metallic sites initially available on the surface are saturated, so that the results of these tests are a measure of the starting number of these surface sites. On the contrary, in the high temperature tests (Example 6) the species initially formed on the surface as a result of gas sorbing can diffuse inwards of the deposit; therefore these tests involve the whole amount of available getter material, and measure the whole capacity of the deposits.

Considering these characteristics, from the three curves graphically shown in Figure 5 it may be inferred that the sample of the invention shows surface sorption characteristics better than those of deposits of metal only or NEG alloy only in the whole measure range. In particular, the sample of the invention (curve 1) shows in the whole measure range sorption rate and capacity greater by more than one order of magnitude than those of a deposit of NEG alloy only (curve 2), and rate and capacity at least double compared to a deposit of titanium only (curve 3). The comparison between curves relating to samples 1 and 2, wherein the exposed surface is made up of the same material, shows that the sample of the invention is characterized by a large specific surface, considerably greater than that obtainable depositing only a getter alloy. The difference of results between curves relating to samples 1 and 3, instead, can be attributed to an activation degree lower for the titanium with respect to getter alloy, when the activation occurs for both materials at the same temperature: a lower activation degree corresponds to a lower surface "cleanness", resulting in a reduced number of sites available for gas sorbing.

The comparison between curves 4 and 5 allows instead to show that in the double-layered deposits of the invention there is an effective transfer of sorbed species from the upper layer of low activation temperature NEG alloy to the lower layer. The two tested samples, indeed, have been manufactured under exactly the same conditions, with the only difference that the sample of curve 5 comprises twice as much titanium as sample 4. As it can be noted, the two curves have the same initial sorption rate, thus confirming that at the beginning of test the two samples are essentially equivalent in specific area and activation degree (as it could be expected); sample 4 however shows a total capacity being about half the capacity of the sample of Example 1; this behavior can be explained only as indication of the fact that the titanium deposit underlying the alloy deposit takes part in sorbing at the test temperature.

From the analysis of above reported tests results it can be thereby concluded that the multilayer deposits of the invention act as if they were a deposit of a single material, each characteristic of which is better than the corresponding characteristic of both the component layers, i.e., the activation temperature of the present material having the lower activation temperature (material of layer 12) and a large surface area (characteristic of layer 11), conferring to the deposit high sorbing performances at room temperature (not obtainable with deposits of getter alloys only). While the replication of the morphology of layer 11 by layer 12 could be expected, it was absolutely not predictable that in the multilayers of the invention the material of lower activation temperature could impart this characteristic to the whole multilayer.

## Claims

1. A multilayer deposit of non-evaporable getter materials, said multilayer deposit having an activation temperature not higher than 300°C and large surface area, **characterized by** comprising at least two layers on a support (10), a first layer (11) directly deposited over said support being made of a non-evaporable getter material having surface area equivalent to at least 20 times its geometrical area and, upon said first layer, at least a second layer (12), having thickness not greater than 1 µm, of a non-evaporable getter alloy with an activation temperature not higher than 300°C, any of said layers being obtained by cathodic deposition and being made of different materials.

2. A deposit according to claim 1, wherein the getter material of said first layer is selected among zirconium, titanium, niobium, tantalum, vanadium, hafnium and a Zr-Co-A alloy wherein A stands for yttrium, lanthanum, Rare Earths or mixtures thereof.

3. A deposit according to claim 1, wherein the thickness of said first layer is comprised between 0.2 and 50 µm.

4. A deposit according to claim 3, wherein said thickness is comprised between 10 and 20 µm.

5. A deposit according to claim 1, wherein the surface area of said first layer is equivalent to at least 50 times its geometrical area.

6. A deposit according to claim 1, wherein the getter alloy of said second layer has percent composition by weight Zr 70% - V 24.6% - Fe 5.4%.

7. A deposit according to claim 1, wherein the getter alloy of said second layer comprises Zr, V, and smaller quantities of one or more elements selected among Fe, Ni, Mn, and Al.

8. A deposit according to claim 1, wherein the getter alloy of said second layer has percent composition by weight Zr 80% - Co 15% - A 5%, wherein A stands for yttrium, lanthanum, Rare Earths or mixtures thereof, and the material of said first layer is different from an alloy Zr-Co-A.

9. A deposit according to claim 1, wherein the getter alloy of said second layer is a Zr-Ti-V alloy.

10. A deposit according to claim 9, wherein said alloy has percent composition by weight Zr 44% - Ti 23% - V 33%.

11. A deposit according to claim 1, wherein the getter alloy of said second layer is ZrV₂.

12. A deposit according to claim 1, wherein the thickness of said second layer is comprised between 50 and 500 nm.

13. A deposit according to claim 1 further comprising a layer, continuous (13) or discontinuous (14, 14', 14", ...) of palladium or a compound thereof, deposited on the surface of said second layer (12) opposed to the one in contact with said first layer (11).

14. A deposit according to claim 13, wherein said palladium compound is selected among palladium oxide, silver-palladium alloys comprising up to atomic 30% of silver and compounds of palladium with one or more metals forming the getter material.

15. A deposit according to claim 13, wherein said discontinuous layer of palladium or a compound thereof covers from 10 to 90% of the second layer surface.

16. A deposit according to one of claims from 13 to 15, wherein said layer of palladium or a compound thereof has a thickness comprised between 10 and 100 nm.

17. A process for manufacturing a multilayer deposit of claim 1 comprising at least the steps of:
- depositing by cathodic deposition on a support (10) a first layer (11) of a non-evaporable getter material having a surface area equivalent to at least 20 times its geometrical area; and
- depositing by cathodic deposition over said first layer at least a second layer (12), having thickness not greater than 1 µm, of a non-evaporable getter alloy having low activation temperature;
without exposing the material of the first layer to gas species able to react therewith, between the two mentioned deposition steps,.

18. A process according to claim 17, in which the cathodic deposition of said first layer is carried out by cooling the support (10) whereon the deposition is carried out and/or operating at low current values and/or operating with the target not directly placed in front of the support and/or moving, rotating or vibrating the support during the deposition.

## Patentansprüche

1. Mehrschichtige Beschichtung aus nicht verdampfbaren Gettermaterialien, die eine Aktivierungstemperatur von nicht höher als 300 °C und eine große Oberfläche besitzt, **dadurch gekennzeichnet, dass** sie mindestens zwei Schichten auf einem Träger (10) umfasst, wobei die erste Schicht (11) aus einem nicht verdampfbaren Gettermaterial hergestellt ist, deren Oberfläche mindestens dem 20fachen ihrer geometrischen Fläche entspricht und diese direkt auf dem Träger aufgebracht ist, auf dieser ersten Schicht mindestens eine zweite Schicht (12) mit einer Dicke von nicht größer als 1 µm aus einer nicht verdampfbaren Getterlegierung mit einer Aktivierungstemperatur von nicht höher als 300 °C aufgebracht ist und jede dieser Schichten durch Kathodenzerstäubung erhalten und aus einem anderen Material hergestellt ist.

2. Beschichtung nach Anspruch 1, wobei das Gettermaterial der ersten Schicht aus Zirconium, Titan, Niob, Tantal, Vanadium, Hafnium und einer Zr-Co-A-Legierung, worin A Yttrium, Lanthan, ein Seltenerdmetall oder ein Gemisch davon bedeutet, ausgewählt ist.

3. Beschichtung nach Anspruch 1, wobei die Dicke der ersten Schicht 0,2 bis 50 µm beträgt.

4. Beschichtung nach Anspruch 3, wobei die Dicke 10 bis 20 µm beträgt.

5. Beschichtung nach Anspruch 1, wobei die Oberfläche der ersten Schicht mindestens dem 50fachen ihrer geometrischen Fläche entspricht.

6. Beschichtung nach Anspruch 1, wobei die prozentuale Gewichtszusammensetzung der Getterlegierung der zweiten Schicht Zr 70 %-V 24,6 %-Fe 5,4 % beträgt.

7. Beschichtung nach Anspruch 1, wobei die Getterlegierung der zweiten Schicht Zr, V und kleinere Mengen an einem oder mehreren Elementen, die aus Fe, Ni, Mn und Al ausgewählt sind, umfasst.

8. Beschichtung nach Anspruch 1, wobei die Getterlegierung der zweiten Schicht die prozentuale Gewichtszusammensetzung Zr 80 %-Co 15 %-A 5 % besitzt, worin A Yttrium, Lanthan, ein Seltenerdmetall oder ein Gemisch davon bedeutet, und sich das Material der ersten Schicht von einer Zr-Co-A-Legierung unterscheidet.

9. Beschichtung nach Anspruch 1, wobei die Getterlegierung der zweiten Schicht eine Zr-Ti-V-Legierung ist.

10. Beschichtung nach Anspruch 9, wobei die prozentuale Gewichtszusammensetzung der Legierung Zr 44 %-Ti 23 %-V 33 % ist.

11. Beschichtung nach Anspruch 1, wobei die Getterlegierung der zweiten Schicht ZrV₂ ist.

12. Beschichtung nach Anspruch 1, wobei die Dicke der zweiten Schicht 50 bis 500 nm beträgt.

13. Beschichtung nach Anspruch 1, die außerdem eine gegebenenfalls diskontinuierliche Schicht (14, 14', 14", ...) aus Palladium oder einer seiner Verbindungen umfasst, die auf der Oberfläche der zweiten Schicht (12), die sich nicht mit der ersten Schicht (11) in Berührung befindet, aufgebracht worden ist.

14. Beschichtung nach Anspruch 13, wobei die Palladiumverbindung aus Palladiumoxid, einer Silber-Palladium-Legierung, die bis zu 30 Atom-% Silber enthält, und einer Verbindung des Palladiums mit einem oder mehreren das Gettermaterial bildenden Metallen ausgewählt ist.

15. Beschichtung nach Anspruch 13, wobei die diskontinuierliche Schicht aus Palladium oder einer seiner Verbindungen 10 bis 90 % der Oberfläche der zweiten Schicht bedeckt.

16. Beschichtung nach einem der Ansprüche 13 bis 15, wobei die Dicke der Schicht aus Palladium oder einer seiner Verbindungen 10 bis 100 nm beträgt.

17. Verfahren zur Herstellung einer mehrschichtigen Beschichtung nach Anspruch 1, das mindestens die Stufen:
- Aufbringen einer ersten Schicht (11) aus einem nicht verdampfbaren Gettermaterial mit einer Oberfläche, die mindestens dem 20fachen ihrer geometrischen Fläche entspricht, auf einen Träger (10) durch Kathodenzerstäubung und
- Aufbringen mindestens einer zweiten Schicht (12) mit einer Dicke von nicht größer als 1 µm aus einer nicht verdampfbaren Getterlegierung mit einer niedrigen Aktivierungstemperatur auf die erste Schicht durch Kathodenzerstäubung
umfasst, ohne dabei zwischen diesen zwei Abscheidungsstufen das Material der ersten Schicht Gasspezies auszusetzen, die in der Lage wären, mit ihm zu reagieren.

18. Verfahren nach Anspruch 17, in welchem die Abscheidung der ersten Schicht durch Kathodenzerstäubung durch Kühlen des Trägers (10), auf welchem diese Abscheidung erfolgt, und/oder Arbeiten bei niedrigen Stromwerten und/oder Arbeiten mit einem Target, das nicht direkt vor dem Träger angeordnet wird, und/oder Bewegen, Drehen oder Schwingen des Trägers während der Abscheidung durchgeführt wird.

## Revendications

1. Dépôt multicouche de matériaux de getter non évaporables, ledit dépôt multicouche ayant une température d'activation pas supérieure à 300°C et une grande aire de surface, **caractérisé en ce qu'**il comprend au moins deux couches sur un support (10), une première couche (11) directement déposée sur ledit support étant réalisée en un matériau de getter non évaporable ayant une aire de surface équivalente à au moins 20 fois son aire géométrique et, sur ladite première couche, au moins une seconde couche (12), ayant une épaisseur pas supérieure à 1 µm, d'un alliage de getter non évaporable ayant une température d'activation non supérieure à 300°C, chacune desdites couches étant obtenue par dépôt cathodique, et étant réalisée en différents matériaux.

2. Dépôt selon la revendication 1, dans lequel le matériau de getter de ladite première couche est sélectionné parmi le zirconium, le titane, le niobium, le tantale, le vanadium, l'hafnium et un alliage Zr-Co-A, A représentant de l'yttrium, du lanthane, des terres rares ou des mélanges de ceux-ci.

3. Dépôt selon la revendication 1, dans lequel l'épaisseur de ladite première couche est comprise entre 0,2 et 50 µm.

4. Dépôt selon la revendication 3, dans lequel ladite épaisseur est comprise entre 10 et 20 µm.

5. Dépôt selon la revendication 1, dans lequel l'aire de surface de ladite première couche est équivalente à au moins 50 fois son aire géométrique.

6. Dépôt selon la revendication 1, dans lequel l'alliage de getter de ladite seconde couche a une composition, en pourcentage en poids, de 70 % de Zr - 24,6 % de V - 5,4 % de Fe.

7. Dépôt selon la revendication 1, dans lequel l'alliage de getter de ladite seconde couche comprend Zr, V, et des quantités inférieures d'un ou de plusieurs éléments sectionnés parmi Fe, Ni, Mn et Al.

8. Dépôt selon la revendication 1, dans lequel l'alliage de getter de ladite seconde couche a une composition, en pourcentage en poids, de 80 % de Zr - 15 % de Co - 5 % de A, A représentant de l'yttrium, du lanthane, des terres rares ou des mélanges de ceux-ci, et le matériau de ladite première couche étant différent d'un alliage Zr-Co-A.

9. Dépôt selon la revendication 1, dans lequel l'alliage de getter de ladite seconde couche est un alliage Zr-Ti-V.

10. Dépôt selon la revendication 9, dans lequel ledit alliage a une composition, en pourcentage en poids, de 44 % de Zr - 23 % de Ti - 33 % de V.

11. Dépôt selon la revendication 1, dans lequel l'alliage de getter de ladite seconde couche est ZrV₂.

12. Dépôt selon la revendication 1, dans lequel l'épaisseur de ladite seconde couche est comprise entre 50 et 500 nm.

13. Dépôt selon la revendication 1, comprenant en outre une couche, continue (13) ou discontinue (14, 14', 14", ...) de palladium ou d'un composé de celui-ci, déposée sur la surface de ladite seconde couche (12) opposée à celle qui est en contact avec ladite première couche (11).

14. Dépôt selon la revendication 13, dans lequel ledit composé de palladium est sectionné parmi de l'oxyde de palladium, des alliages argent-palladium comprenant jusqu'à 30 % en atome d'argent et de composés de palladium avec un ou plusieurs métaux formant le matériau de getter.

15. Dépôt selon la revendication 13, dans lequel ladite couche discontinue de palladium ou d'un composé de celui-ci couvre de 10 à 90 % de la surface de la seconde couche.

16. Dépôt selon l'une quelconque des revendications 13 à 15, dans lequel ladite couche de palladium ou d'un composé de celui-ci a une épaisseur comprise entre 10 et 100 nm.

17. Procédé de fabrication d'un dépôt multicouche selon la revendication 1, comprenant au moins les étapes consistant à :
- déposer, par dépôt cathodique sur un support (10), une première couche (11) d'un matériau de getter non évaporable présentant une aire de surface équivalente à au moins 20 fois son aire géométrique, et
- déposer, par dépôt cathodique sur ladite première couche, au moins une seconde couche (12), ayant une épaisseur pas supérieure à 1 µm, d'un alliage de getter non évaporable ayant une température d'activation basse,
sans exposer le matériau de la première couche à des espèces de gaz susceptibles de réagir avec celui-ci, entre les deux étapes de dépôt mentionnées.

18. Procédé selon la revendication 17, dans lequel le dépôt catholique de ladite première couche est mis en oeuvre en refroidissant le support (10) sur lequel le dépôt est mis en oeuvre et/ou en fonctionnement avec des valeurs de courant électrique faibles et/ou en fonctionnant avec la cible qui n'est pas placée directement devant le support et/ou en déplaçant, en faisant tourner ou en faisant vibrer le support pendant le dépôt.
